# EUROPÄISCHE PATENTANMELDUNG

(11) **EP 0 580 568 A2**
(43) Veröffentlichungstag der Anmeldung: **26.01.1994**
(21) Anmeldenummer: 93890144.4
(22) Anmeldetag: 21.07.1993
(51) Int. Cl.: H01S 3/096, H01S 3/103, H01S 3/133

(54) **Vorstromregelung für Laserdiode**

(30) Priorität: 21.07.1992 AT 1492/92
(71) Anmelder: Alcatel Austria Aktiengesellschaft, A-1210 Wien (AT)
(72) Erfinder: Hahn, Alois, A-1210 Wien (AT); Hiebeler, Markus, Dipl.-Ing., A-1050 Wien (AT); Hirn, Richard, Dipl.-Ing., A-1200 Wien (AT); Lauritsch, Franz, A-8010 Graz (AT)

(57) **Zusammenfassung**

Verfahren zur Regelung des Vorstromes einer mit einer Monitordiode in einem Regelkreis mit Operationsverstärkern zusammenwirkenden Laserdiode, umfassend Signalverarbeitungsfilter, eine elektrische Versorgungseinheit, wie z.B. eine Stromquelle, und einen Nulldurchgangsdetektor, wobei die Laserdiode (5a) von einem von der Versorgungseinheit abgegebenen linearen Stromrampensignal betrieben wird, daß das Ausgangssignal (16) der Monitordiode (15) dreifach differenziert wird, und daß bei Erkennen eines Nulldurchganges des dreifach differenzierten Monitordioden-Ausgangssignals (16) durch den Nulldurchgangsdetektor eine Optimalstromstärke des Stromrampensignalgenerators festgehalten wird.

## Beschreibung

Die Erfindung betrifft ein Verfahren zur Regelung des Vorstromes einer mit einer Monitordiode in einem Regelkreis mit Operationsverstärkern zusammenwirkenden Laserdiode, umfassend Signalverarbeitungsfilter, eine elektrische Versorgungseinheit, wie z.B. eine Stromquelle, und einen Nulldurchgangsdetektor sowie eine Einrichtung zur Durchführung dieses Verfahrens, mit einem Addierer zur Überlagerung des Vorstromes und eines Modulationsstromes, und einer den Vorstrom liefernden steuerbaren Stromquelle sowie einer mit der Monitordiode verbundenen Auswerteschaltung.

In Systemen der optischen Nachrichtentechnik hat sich die Verwendung von Halbleiterlasern als vorteilhaft erwiesen, insbesonders durch die Modulierbarkeit höherer Frequenzen sowie verlustarmer Signalübertragungen über große Übertragungslängen ohne Zwischenverstärker.

Um den Halbleiter-Laser schnell modulieren zu können, muß dieser wahrend der Datenübertragung mit einem Vorstrom beaufschlagt sein, der etwas über dem Schwellstrom liegt. Zu diesem Vorstrom wird dann der Modulationsstrom addiert. Dabei müssen jedoch die durch Alterung und Temperaturschwankungen hervorgerufenen Fluktuationen des Schwellstromes durch eine Regelschaltung kompensiert werden.

Es ist üblich, durch Abtasten des Strom-Spannungsverlaufes der Laserdiode den aktuellen Schwellstrom zu ermitteln, dessen Größe als Ausgangswert für eine Regelung des Vorstromes dient (Zeitschrift Elektronik 22/85, S.91). Die Regelung hat insbesondere die Aufgabe, Maximum und Minimum der Lichtleistung bei Laserbetrieb konstant zu halten.

Es ist weiters zur Messung der vom Laser emittierten Lichtleistung üblich, wie etwa in US-4,344 173, im Gehäuse einer Laserdiode eine Monitordiode zu integrieren, die einen zur optischen Laserleistung direkt proportionalen Sperrstrom liefert. Der Kopplungsgrad zwischen Laserdiode und Monitordiode und damit auch der Proportionalitatsfaktor zwischen Lichtleistung und Monitorstrom ist jedoch starker Exemplarstreuung unterworfen.

Daher muß die Vorstromregelung einer Laserdiode vor der ersten Inbetriebnahme abgeglichen werden, damit die Regelschaltung die tatsächlich abgegebene Lichtleistung erfassen kann. Die Regelung erfolgt bekannterweise entweder nach der optischen Leistung bei Betreiben der Laserdiode mit Vorstrom, wobei die Lichtleistung ohne Modulationsstrom auf einen bestimmten Wert eingestellt wird, oder nach dem Mittelwert der optischen Ausgangsleistung, der sich bei kontinuierlicher Modulation ergibt, wobei der durch die gegebene Lichtleistung in der Monitordiode erzeugte Sperrstrom mit einem Referenzwert verglichen wird (Zeitschrift Elektronik 22/85, S.91-92).

Diese bekannten Methoden benötigen aber zur genauen Funktion einen Abgleichvorgang, weil der Proportionalitatsfaktor zwischen optischer Leistung und Monitorstrom nicht bekannt ist.

Aufgabe der Erfindung ist es daher, diesen bekannten Nachteil zu vermeiden und eine Regelung vorzusehen, welche eine selbstjustierende Vorstromregelung einer Laserdiode ermöglicht.

In der US-4,344 173 wird zwar ebenfalls ein Regelkreis zum Einstellen des Vorstromes einer Laserdiode, der aus einer Stromquelle, einem Bandpaßfilter und einem Nulldurchgangsdetektor besteht, verwendet, in dieser Anordnung wird aber eine Oberwellenanalyse durchgeführt, die einen hohen Aufwand zur Folge hat.

Die Erfindung löst die Aufgabe dadurch, daß die Laserdiode von einem von der Versorgungseinheit abgegebenen linearen Stromrampensignal betrieben wird, daß das Ausgangssignal der Monitordiode dreifach differenziert wird, und daß bei Erkennen eines Nulldurchganges des dreifach differenzierten Monitordioden-Ausgangssignals durch den Nulldurchgangsdetektor eine Optimalstromstarke des Stromrampensignalgenerators festgehalten wird.

Vorteilhafterweise weist bei Betreiben der Laserdiode mit einem linearen Stromrampensignal ihre optische Ausgangsleistung in Abhängigkeit von der Zeit einen ihrer optischen Ausgangsleistung in Abhängigkeit des Injektionsstromes identen Verlauf auf. Dies ermöglicht eine selbsttätige Einstellung des Laservorstromes auf einen Optimalwert, der bei Nulldurchgang der dritten Ableitung der Laserleistung nach dem Strom, welche der dritten Ableitung der optischen Ausgangsleistung nach der Zeit bei Betreiben der Laserdiode mit einem linearen Rampensignal entspricht, vorliegt. Der Vorstrom-Arbeitspunkt wird somit auf den Stromwert eingestellt, bei dem die dritte Ableitung durch Null geht, wodurch ein Extremwert, in diesem Fall ein Maximum, der Krümmung der Leistungskurve charakterisiert ist.

In weiterer Ausgestaltung der Erfindung kann vorgesehen sein, daß die Optimalstromstärke nach einer Verzögerungszeitspanne festgehalten wird.

Eine derartige Verzögerungszeitspanne kann zur weiteren Abstimmung des optimalen Vorstromwerts vorteilhaft sein, da es sich aus Erfahrungswerten ergeben kann, daß ein um einen bestimmten Prozentsatz höherer Wert je nach Typ der Laserdiode besser geeignet ist.

Die Erfindung löst die oben angegebene Aufgabe auch mittels einer Einrichtung zur Durchführung des oben genannten Verfahrens mit einem Addierer zur Überlagerung des Vorstromes und eines Modulationsstromes, und einer den Vorstrom liefernden steuerbaren Stromquelle, sowie einer mit der Monitordiode verbundenen Auswerteschaltung, welche dadurch gekennzeichnet ist, daß ein an sich bekannter Rampensignalgenerator die die Laserdiode betreibende, steuerbare Stromquelle durch ein lineares Rampensignal ansteuert, und daß die Auswerteschaltung eine das Ausgangssignal der Monitordiode dreifach differenzierende Schaltung umfaßt, die über einen den Nulldurchgang des dreifach differenzierten Monitordioden-Ausgangssignals feststellenden Komparator mit einer den Rampensignalgenerator steuerenden Steuereinheit verbunden ist.

Ein weiteres Merkmal der Erfindung ist es, daß zwischen dem Rampengenerator und der steuerbaren Stromquelle ein mit diesen verbundener, von der Steuereinheit ansteuerbarer Schalter angeordnet ist.

Dadurch kann der Laservorstrom während einer Modulationspause etwa aus Energiespargründen unterbrochen werden, ohne daß der im Rampengenerator gespeicherte, optimale Wert des Laservorstromes verlorengeht, wobei sowohl der Rampengenerator als auch der Schalter von der Steuereinheit angesteuert wird.

Ein weiteres Merkmal der Erfindung ist es, daß die Auswerteschaltung drei in Serie geschaltete, an sich bekannte aktive Filter umfaßt, denen der Komparator nachgeschaltet ist.

Die Differenzierung des Ausgangssignales der Monitordiode kann damit auf einfache Weise durchgeführt werden, da die aktiven Filter im vorgegebenen Frequenzbereich wie eine Kaskade dreier Differenzierer wirken.

Vorteilhafterweise werden Bandpaßfilter 1.Ordnung als die drei aktiven Filter verwendet.

Die Erfindung wird nun anhand eines Ausführungsbeispieles unter Zuhilfenahme der angeschlossenen Zeichnungen näher beschrieben.

Es zeigen Fig. 1 eine statische Laserkennlinie nach dem Stand der Technik; Fig.2 ein Blockschaltbild der erfindungsgemäßen Einrichtung zur Regelung des Vorstromes einer Laserdiode; Fig.3 ein Ausführungsbeispiel der erfindungsgemäßen Auswerteschaltung; und Fig.4 ein Diagramm der Signalverläufe in der Auswerteschaltung.

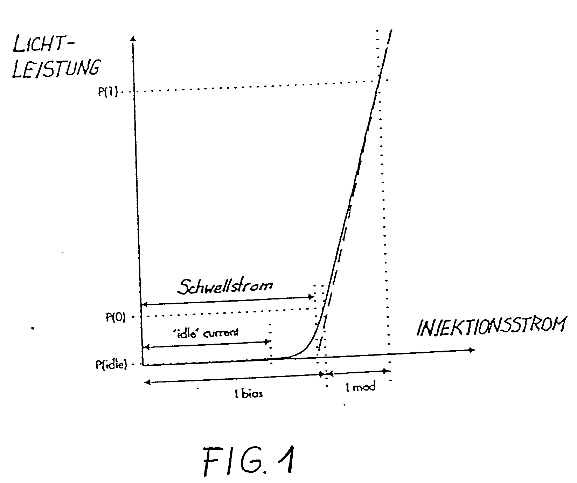

Fig.1 zeigt eine aus dem Stand der Technik bekannte Kennlinie der optischen Ausgangsleistung einer Laserdiode in Abhängigkeit vom Injektionsstrom, welche einen Knick aufweist, dessen Position in Abhängigkeit von der Temperatur sowie aufgrund der Alterung unterschiedlich sein kann. Der Knick liegt im Bereich des Schwellstromes, welcher einer Exemplarstreuung sowie temperatur- und alterungsbedingten Schwankungen unterworfen ist. Die Kurvenform der Kennlinie entspricht einer Hyperbel, der Knickpunkt der Kennlinie liegt im Punkt der maximalen Krümmung.

Das Diagrarnm zeigt weiters die Beträge des Vorstromes I_{bias} sowie des Modulationsstromes I_{mod}. Der Vorstrom liegt dabei etwas über dem Schwellstrom, dessen Fluktuation durch eine Regelschaltung kompensiert wird.

Die Regelung des Vorstromes einer Laserdiode wird insbesonders an einem passiven optischen Netzwerk beschrieben.

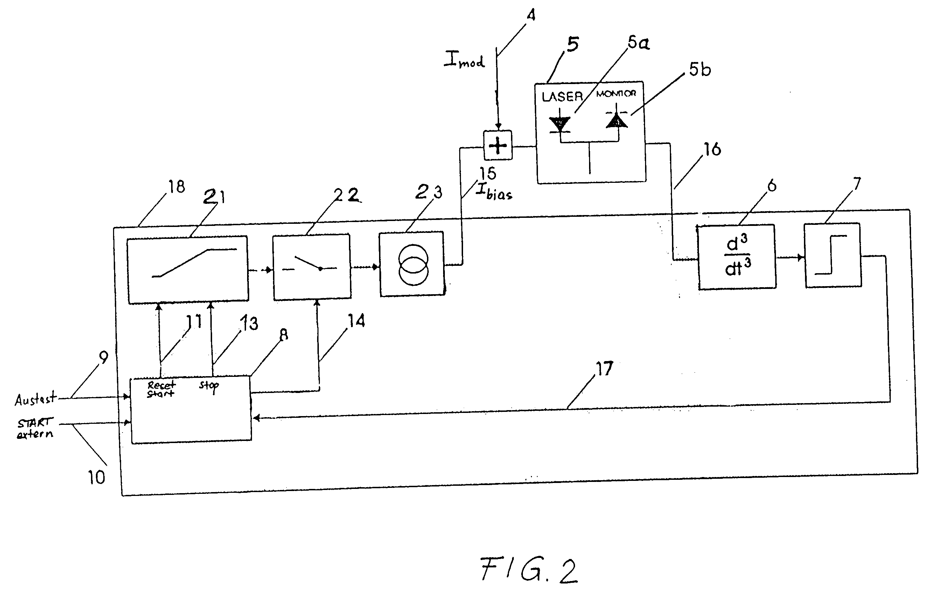

Fig.2 zeigt eine komplette Laservorstromregelung 18 anhand eines Blockschaltbildes. Dabei wird die in einer Einheit 5 mit der Monitordiode 5b in Wechselwirkung stehende Laserdiode 5a mit kontinuierlich ansteigendem Strom aus einer steuerbaren Stromquelle 23 betrieben, welche von einem linearen Rampensignal aus einem Rampensignalgenerator 21, der vom Zeitpunkt, an dem er gestartet wird, ein von Null mit konstanter Steigung mit der Zeit ansteigendes Signal abgibt, angesteuert wird. Zufolge dieser Schaltung entspricht die optische Ausgangsleistung in Abhängigkeit von der Zeit der optischen Ausgangsleistung in Abhängigkeit vom Injektionsstrom. Zwischen dem Rampengenerator 21 und der steuerbaren Stromquelle 23 ist ein gesteuerter Schalter 22 angeordnet, welcher den Laservorstrom I_{bias} 15 unterbrechen kann. Dabei bleibt der im Rampengenerator gespeicherte Wert des Laservorstromes erhalten. Zum Vorstrom I_{bias} 15 wird im Addierer 4 der Modulationsstrom I_{mod} hinzuaddiert.

Das aus der Monitordiode 5b austretende Ausgangssignal 16 wird einer Auswerteschaltung 6 zugeführt, dort dreifach differenziert und das daraus resultierende Signal an den Eingang des nachgeschalteten Komparator 7 gelegt, der bei Auftreten eines Nulldurchganges ein Steuersignal über die Leitung 17 an die Steuereinheit 8 abgibt. Diese Steuereinheit 8 steuert sowohl den Rampengenerator 21 alsauch den Schlater 22 und bewirkt bei Vorliegen eines Austast-Signals an der Leitung 9 das Abschalten des Vorstromes. Ein externes Signal auf Leitung 10 veranlaßt den Start einer neuen Meßrampe. Das Rücksetzen verbunden mit gleichzeitigem Startsignal des Rampensignalgenerators 21 erfolgt über ein durch die Steuereinheit 8 generiertes Signal auf der Leitung 11, das Anhalten und damit Festhalten des Augenblickwertes des Rampensignalstroms mit einem ebenfalls von der Steuereinheit erzeugtem Signal auf Leitung 13.

Am Meßbeginn wird, bei geschlossenem Schalter 22, der Rampengenerator 21 jeweils über das Signal 11 rückgesetzt und gestartet. Das von Null an anwachsende Rampensignal des Rampensignalgenerators 21 steuert die Stromquelle 23, die einen gleichfalls ansteigenden Vorstrom zum Betreiben der Laserdiode 5a abgibt. Die Monitordiode 5b wandelt die Lichtleistung der Laserdiode 5a in ein Ausgangssignal um, welches in der Auswerteschaltung 6 dreifach differenziert wird. Das dabei entstehende Signal wird dem Eingang des Komparators 7 zugeführt, der bei einem Nulldurchgang dieses an seinem Eingang anliegenden Signals ein Ausgangssignal an die Leitung 17 abgibt. Bei Vorliegen dieses Ausgangssignals erzeugt die Steuereinheit 8 nach einer vorwahlbaren Zeitverzögerung an ihrem Ausgang 13 ein Stop-Signal, womit ein Festhalten und ein Speichern des Augenblickwertes des Rampensignals erreicht wird. Damit ist der optimale Wert des Vorstromes für einen Regeldurchlauf festgelegt und die Stromquelle 23 behält diesen Wert bis zum Ende des nächsten Durchlaufs bei. Durch das Speichern des Rampensignals geht dieser Wert auch nicht verloren, wenn über ein Austastsignal 9 der Schalter 22 geöffnet wird. Dies erfolgt beispielsweise zur Schonung der Laserdiode, wenn gerade keine Daten übertragen werden.

Indem die Position des Maximums der Krümmung der Kennlinie der optischen Ausgangsleistung einer Laserdiode und damit näherungsweise auch die Position des Nulldurchganges der 3.Ableitung unabhängig von konstanten Verstärkungsfaktoren ist und die Laserdiode mit einem linearen Stromrampensignal betrieben wird, kann der Laserschwellstrom ohne vorherigen Abgleich ermittelt werden. Der ideale Vorstrom ist immer um den gleichen Betrag größer als der Schwellstrom und kann daher ohne weitere Rückmeldung von der Laservorstromregelung 18 ermittelt werden.

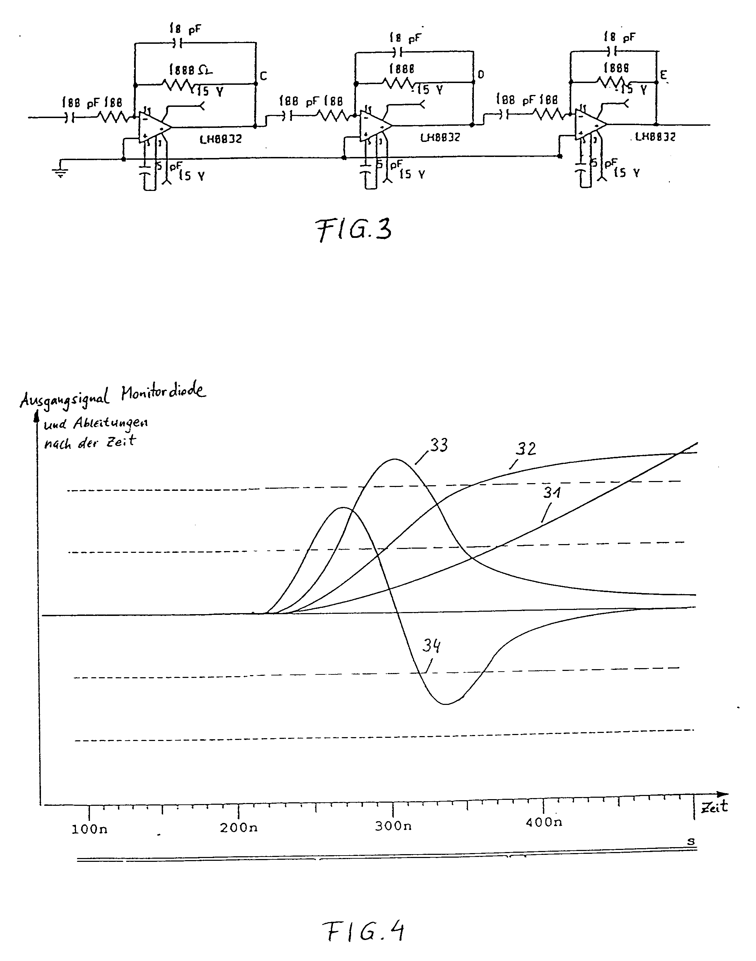

Fig.3 zeigt ein Ausführungsbeispiel der Auswerteschaltung 6 aus drei in Serie geschalteten, an sich bekannten Bandpaßfiltern 1. Ordnung, welche die Differenzierung des Signales 16 durchführen , und an welche der nicht dargestellte Komparator 7 anschließt. Vorteilhafterweise wird zur Verringerung der Schwingungsneigung der Schaltung die Verstärkung auf den Wert 10 pro Stufe begrenzt. Um die aktiven Filter als Differenzierer mit linearem Phasengang einsetzen zu können, muß die Eckfrequenz der Filter über der höchsten signifikanten Spektrallinie des Eingangssignales 16 liegen. Die Ableitungen des Eingangssignales 16 werden an den mit C,D.E gekennzeichneten Stellen abgenommen.

Die bei der Differenzierung in der Auswerteschaltung 6 auftretenden Signalverläufe sind in Fig.4 dargestellt. Der Kurvenzug 31 entspricht dem Eingangssignal 16, welches mit der Laserkennlinie ident ist. Die dargestellten Kurvenzüge 32,33 und 34 entsprechen der ersten, zweiten bzw. dritten Ableitung des Eingangssignales 16 und wurden an den mit C,D,E in der Fig.4 bezeichneten Stellen der Filter abgenommen.

Es zeigt sich eine vernachlässigbare Abhängigkeit des Nulldurchganges der dritten Ableitung 34 des Eingangssignales 16 und eine geringe Beeinflussung des Signales durch Rauschen.

Da der Laserchip Temperaturschwankungen unterworfen ist, muß eine regelmäßige Einstellung des Vorstromes durchgeführt werden, während der der Laser nicht moduliert werden kann. Es empfiehlt sich daher, im Protokoll des Netzwerkes ein eigenes Zeitfenster für den Einstellvorgang vorzusehen, in welchem Zeitraum keine Datenübertragung stattfindet.

## Patentansprüche

1. Verfahren zur Regelung des Vorstromes einer mit einer Monitordiode in einem Regelkreis mit Operationsverstärkern zusammenwirkenden Laserdiode, umfassend Signalverarbeitungsfilter, eine elektrische Versorgungseinheit, wie z.B. eine Stromquelle, und einen Nulldurchgangsdetektor, **dadurch gekennzeichnet,** daß die Laserdiode (5a) von einem von der Versorgungseinheit abgegebenen linearen Stromrampensignal betrieben wird, daß das Ausgangssignal (16) der Monitordiode (15) dreifach differenziert wird, und daß bei Erkennen eines Nulldurchganges des dreifach differenzierten Monitordioden-Ausgangssignals (16) durch den Nulldurchgangsdetektor eine Optimalstromstärke des Stromrampensignalgenerators festgehalten wird.

2. Verfahren nach Anspruch 1, **dadurch gekennzeichnet,** daß die Optimalstromstarke nach einer Verzogerungszeitspanne festgehalten wird.)

3. Einrichtung zur Durchführung des Verfahrens nach Anspruch 1 oder 2, mit einem Addierer zum Überlagern des Vorstromes und eines Modulationsstromes, und einer den Vorstrom liefernden, steuerbaren Stromquelle, sowie einer mit der Monitordiode verbundener Auswerteschaltung, **dadurch gekennzeichnet,** daß ein an sich bekannter Rampensignalgenerator (21) die die Laserdiode (5a) betreibende, steuerbare Stromquelle (23) durch ein lineares Rampensignal ansteuert, und daß die Auswerteschaltung (6) eine das Ausgangssignal (16) der Monitordiode (5b) dreifach differenzierende Schaltung umfaßt, die über einen den Nulldurchgang des dreifach differenzierten Monitordioden-Ausgangssignals feststellenden, an sich bekannten Komparator (7) mit einer den Rampensignalgenerator (21) steuernden Steuereinheit (8) verbunden ist.

4. Einrichtung nach Anspruch 3, **dadurch gekennzeichnet,** daß zwischen dem Rampensignalgenerator (21) und der steuerbaren Stromquelle (23) ein mit diesen verbundener, von der Steuereinheit (8) ansteuerbarer Schalter (22) angeordnet ist.

5. Einrichtung nach Anspruch 3 oder 4, **dadurch gekennzeichnet,** daß die Auswerteschaltung (6) drei in Serie geschaltete, an sich bekannte aktive Filter umfaßt, denen der Komparator (7) nachgeschaltet ist.

6. Einrichtung nach Anspruch 5, **dadurch gekennzeichnet,** daß die drei aktiven Filter an sich bekannte Bandpaßfilter 1.Ordnung sind.
